Europäisches Patentamt

European Patent Office

Office européen des brevets

(19)

(11) EP 0 632 598 B1

(12) **FASCICULE DE BREVET EUROPEEN**

(45) Date de publication et mention
de la délivrance du brevet:
**23.12.1998 Bulletin 1998/52**

(51) Int Cl.[6]: **H03M 7/16**, H03M 1/36

(21) Numéro de dépôt: **94201861.5**

(22) Date de dépôt: **28.06.1994**

(54) **Encodeur thermométrique-binaire tolérant aux erreurs**

Fehlertoleranter Thermomer-Binärkodierer

Error tolerant thermometric to binary encoder

(84) Etats contractants désignés:
**DE FR GB IT**

(30) Priorité: **30.06.1993 FR 9308005**

(43) Date de publication de la demande:
**04.01.1995 Bulletin 1995/01**

(73) Titulaire: **Koninklijke Philips Electronics N.V.
5621 BA Eindhoven (NL)**

(72) Inventeurs:
• **Van Valburg, Christinus, Société Civile S.P.I.D.
F-75008 Paris (FR)**
• **Van de Plassche, Rudy, Société Civile S.P.I.D.
F-75008 Paris (FR)**

(74) Mandataire: **Charpail, François et al
Société Civile S.P.I.D.
156, Boulevard Haussmann
75008 Paris (FR)**

(56) Documents cités:
**EP-A- 0 328 215**

• **IEEE JOURNAL OF SOLID-STATE CIRCUITS,
vol.23, no.6, Décembre 1988 pages 1334 - 1344
VAN DE PLASSCHE ET AL 'AN 8-BIT 100-MHZ
FULL-NYQUIST ANALOG-TO-DIGITAL
CONVERTER'**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition. (Art. 99(1) Convention sur le brevet européen).

## Description

La présente invention concerne un encodeur pour la conversion d'un signal numérique d'entrée défini selon un code de type thermométrique ou circulaire dont chaque bit est appliqué à une entrée de l'encodeur, pour obtenir un signal de sortie codé en binaire, encodeur comportant un jeu de n portes OU Exclusif successives, à deux entrées et une sortie, chaque porte OU Exclusif ayant une entrée reliée à une entrée de la porte de rang voisin ainsi qu'à une entrée de l'encodeur, et comportant une matrice d'encodage à n lignes en entrée et une pluralité de paires de colonnes en sortie, chacune des n lignes successives étant reliée à une sortie d'une des portes OU Exclusif successives, chacune des colonnes étant connectée à une borne de tension de référence via une source de courant et les colonnes d'une paire fournissant une sortie différentielle pour un bit du signal binaire de sortie, matrice d'encodage dans laquelle un couplage actif entre une ligne déterminée et une colonne déterminée est constitué, lorsqu'il est requis, par un transistor dont la base est reliée à ladite ligne déterminée, dont l'émetteur est relié à ladite colonne déterminée et dont le collecteur est relié à une borne de tension d'alimentation.

Un tel encodeur est connu de l'article intitulé "8 bit 100MHz full-Nyquist A/D Converter" publié dans IEEE Journal of Solid-State Circuits, Vol 23, N°6 décembre 1988, pp.1334-1344. Une description de cet encodeur réalisé en technologie bipolaire est particulièrement décrite en liaison avec les figures 7 et 13 de cette publication.

Une application majeure d'un encodeur binaire du type indiqué plus haut est celle des convertisseurs analogiques-numériques. Dans cette application, un problème technique bien connu est posé par la présence d'erreurs de décision logique à la sortie du jeu de portes OU Exclusif.

Le document EP-A-0 328 215, par exemple, décrit un convertisseur analogique-numérique comprenant un circuit de correction pour code thermométrique.

La mesure de la valeur d'un signal analogique, par comparaison avec les tensions prélevées sur une échelle de résistances devrait normalement fournir un signal numérique thermométrique dont les bits successifs ne comportent qu'une seule transition entre un groupe de bits de rang successifs à 1 et un groupe restant de bits de rangs successifs à 0. A la sortie du jeu de portes OU Exclusif, une seule sortie à 1 devrait donc normalement être constatée.

Par suite de légères imperfections dans la réalisation des convertisseurs, des erreurs de décision sont observées, particulièrement lorsqu'on augmente la fréquence du signal analogique à mesurer. Une erreur de décision, appelée ci-après erreur simple, consiste dans le fait que les bits du signal thermométrique observé à un instant donné, contiennent une transition (1...1), 0, 1, 0 (0....0).

Le jeu de portes OU Exclusif fait donc apparaître dans ce cas un signal à 1 sur trois sorties de rangs successifs, au lieu d'une seule sortie. D'autres erreurs plus graves parcequ'elles impliquent plus de trois sorties successives du jeu de portes, sont encore possibles mais elles sont nettement moins fréquentes que les erreurs dites simples, et devraient être évitées par une construction plus soignée du convertisseur.

La présente invention a pour objet de proposer un encodeur dont l'agencement particulier permet de corriger automatiquement les erreurs de décision simples, de manière sûre et rapide.

En effet, selon la présente invention, un encodeur du type indiqué dans le paragraphe introductif, est notamment remarquable en ce que la matrice d'encodage comporte une paire de colonnes appelées respectivement pseudo-colonne de poids zéro et pseudo-colonne complémentaire de poids zéro, dont le couplage lignes/colonnes est respectivement déduit par décalage circulaire à partir du couplage lignes/colonnes de la paire de colonnes de poids un, à savoir : pour une ligne de rang i de la pseudo-colonne de poids zéro, est appliqué un couplage identique à celui de la ligne de rang (i modulo n) + 1 de la colonne de poids un, de même pour la ligne de rang i de la pseudocolonne complémentaire de poids zéro, est appliqué un couplage identique à celui de la ligne de rang (i modulo n) + 1 de la colonne complémentaire de poids un,

et en ce que l'encodeur comporte une porte OU Exclusif additionnelle à deux entrées dont l'une reçoit un signal logique correspondant à la sortie de la paire de pseudo-colonnes de poids zéro et l'autre reçoit un signal logique correspondant à la sortie de la paire de colonnes de poids un, cette porte OU Exclusif additionnelle fournissant en sortie le bit de poids zéro du signal binaire de sortie.

Par une analyse dont le détail sera exposé plus loin, il apparaît qu'une erreur de décision simple fournit, pour les bits de poids supérieur à zéro du signal binaire de sortie, des signaux différentiels sur les paires de colonnes de la matrice d'encodage dont l'amplitude est réduite, mais qui sont corrects du point de vue logique.

L'invention met en oeuvre une structure particulière pour l'encodage du bit de poids zéro du signal binaire de sortie, structure telle qu'en présence d'une erreur de décision simple, le signal fourni par la paire de pseudo-colonnes de poids zéro est significatif du point de vue logique, bien que d'amplitude réduite. Toutefois, la paire de pseudocolonnes de poids zéro ne fournit pas directement le bit de poids zéro du signal binaire de sortie mais un signal numérique qui est à combiner à travers la porte OU-Exclusif additionnelle, avec le signal issu de la paire de colonnes de poids 1.

L'invention permet donc une correction automatique des erreurs de décision simples.

Selon un mode de mise en oeuvre avantageux de l'invention, l'encodeur est caractérisé en ce que chacune des paires de colonnes de la matrice d'encodage est suivie d'un amplificateur différentiel de gain suffisant pour forcer le niveau de signal à sa sortie à prendre l'un parmi deux niveaux logiques prédéterminés, en présence d'une erreur de décision simple à la sortie du jeu de portes OU Exclusif.

On retrouve à la sortie de ces amplificateurs des signaux dont les niveaux sont élevés aux valeurs standards lorsqu'une erreur de décision est présente.

En cas d'erreur, le signal différentiel appliqué à l'entrée des amplificateurs est petit, de l'ordre de 18mV seulement. Il peut être augmenté au sein même de la matrice d'encodage conformément à un mode de mise en oeuvre de l'invention caractérisé en ce que dans la matrice d'encodage, chaque transistor réalisant un couplage actif ligne/colonne est muni d'une résistance d'émetteur dont la valeur est choisie de manière à ce que le niveau différentiel de tension de la sortie d'une paire de colonnes, en présence d'une erreur de décision simple à la sortie des portes OU Exclusif, soit rendu comparable au niveau différentiel de tension qui est produit en l'absence d'une telle erreur.

En appliquant cette disposition, le niveau différentiel de tension en l'absence d'erreur, est toutefois réduit par comparaison avec une matrice d'encodage dont les transistors ne sont pas munis de résistance d'émetteur. Un compromis est donc souhaitable en ce qui concerne le choix de la valeur des résistances d'émetteur. Si le niveau différentiel de tension en sortie des paires de colonnes en présence d'une erreur de décision est rendu comparable à celui obtenu en l'absence d'erreur, les amplificateurs de sortie des colonnes de la matrice d'encodage peuvent être simplifiés et le fonctionnement de l'encodeur est amélioré.

L'invention concerne également un convertisseur analogique/numérique incorporant un encodeur tel que défini précédemment.

La description qui va suivre en regard des dessins annexés, donnés à titre d'exemple non limitatif, fera bien comprendre en quoi consiste l'invention et comment elle peut être réalisée.

La figure 1 représente une vue partielle et schématique d'un encodeur selon l'invention.

La figure 2 illustre le cas d'une erreur de décision simple par comparaison avec la situation normale, sans erreur, à la sortie des portes OU Exclusif.

La figure 3 est une table illustrant dans la sortie codée en binaire de l'encodeur selon l'invention, comment le bit de poids 0 est obtenu à partir de la sortie des pseudo-colonnes de poids 0.

Les figures 4 et 5 montrent des schémas illustrant respectivement la situation d'un encodage normal et d'un encodage en présence d'une erreur de décision.

La figure 6 montre le schéma d'un mode particulier de réalisation de l'invention,

et la figure 7 représente des courbes de variations des niveaux différentiels de tension produits en sortie des paires de colonnes, d'une part en l'absence d'erreur et d'autre part en présence d'une erreur de décision, en fonction de la valeur d'une résistance d'émetteur selon le mode de mise en oeuvre décrit à la figure 6.

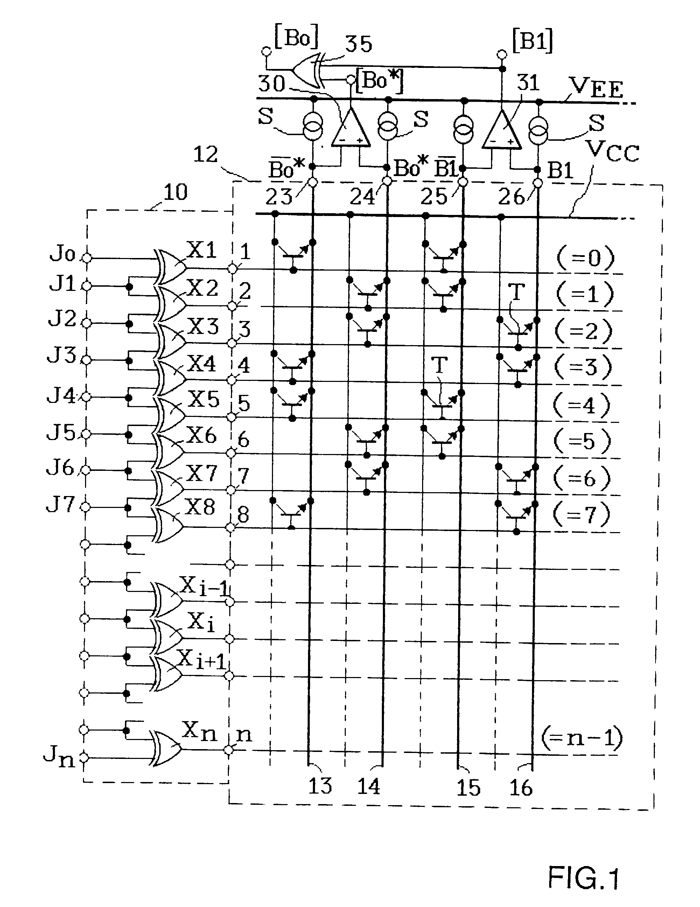

A la figure 1, un encodeur selon l'invention comporte un jeu de n portes OU Exclusif 10 dont chacune des portes X1, X2...Xi...Xn, de rangs successifs, possède deux entrées et une sortie. Chacune des portes Xi a une entrée reliée à une entrée de la porte Xi-1 ainsi qu'à une entrée $J_i$-1 de l'encodeur, l'autre entrée de la porte Xi étant reliée à une entrée de la porte Xi+1 ainsi qu'à une entrée Ji de l'encodeur. L'encodeur comporte encore une matrice d'encodage 12, à n lignes de rangs successifs dont chacune est reliée à la sortie de chaque porte OU Exclusif Xi, et des paires de colonnes en sortie 13-14, 15-16, ... le nombre de ces paires de colonnes étant égal au nombre de bits du signal à coder en binaire à la sortie de l'encodeur.

Chacune des colonnes 13, 14, 15, 16... est connectée à une borne de tension de référence VEE via une source de courant S et les colonnes d'une paire 13-14, 15-16, ..... fournissant une sortie différentielle 23-24, 25-26, ..... pour un bit du signal binaire de sortie $[B_o]$, $[B_1]$...

Dans l'exemple, l'encodeur est destiné à fournir des sorties binaires s'étendant de la valeur 0 à la valeur (n-1).

A cet effet, la ligne dite de rang 1 est à l'état haut pour la valeur 0 en sortie, et la ligne de rang n est à l'état haut pour la valeur (n-1) en sortie. Pour réaliser ces conditions, l'entrée Jo est fixée à un niveau haut et l'entrée Jn est fixée à un niveau bas, et ceci en permanence. Lorsqu'une ligne est active, elle détermine en sortie de l'encodeur, une valeur binaire dont l'équivalent décimal est indiqué entre parenthèses, à droite de la figure 1.

Dans la matrice d'encodage 12, un couplage actif entre une ligne et une colonne est constitué, lorsqu'il est nécessaire, par un transistor T dont la base est reliée à une ligne, dont l'émetteur est relié à une colonne et dont le collecteur est relié à une borne d'alimentation VCC.

Ainsi la colonne 15 fournit à sa sortie 25 un signal $\overline{B}1$ cette colonne étant couplée à cet effet aux lignes de rangs 1, 2, 5, 6,... De manière analogue la colonne 16 fournit en sortie 26 un signal B1 et elle est couplée aux lignes de rangs 3, 4, 7, 8...

Les signaux B1 et $\overline{B}1$ sont appliqués à l'entrée d'un amplificateur différentiel 31 fournissant en sortie un signal [B1] correspondant au bit de poids 1 de la sortie binaire de l'encodeur.

La paire de colonne 13 et 14 est appelée paire de pseudo-colonnes de poids 0 du fait qu'elle est couplée aux lignes de sortie du jeu de portes OU Exclusif 10 par décalage circulaire à partir du couplage ligne/colonne de la paire de colonnes 15, 16 de poids 1.

Ainsi le couplage de la colonne 13 se déduit du couplage de la colonne 15 mais en reportant ce couplage à une ligne de rang immédiatement inférieur. La colonne 14 est de manière similaire couplée aux lignes de sortie du jeu de portes OU Exclusif 10 d'une manière comparable au couplage de la colonne 16 mais en reportant ce couplage à des lignes de rangs immédiatement inférieurs. Pour préciser le couplage des pseudo-colonnes de poids 0 avec les lignes de rangs extrêmes, on peut exprimer ce couplage en disant que pour une ligne de rang i des pseudo-colonnes de poids 0, on applique un couplage identique à celui de la ligne de rang (i modulo n)+1 des colonnes de poids 1. La paire de pseudo-colonnes 13 et 14 fournit en sortie, respectivement 23 et 24, les signaux $\bar{B}0$ * et B0*. Ces signaux sont appliqués à l'entrée d'un amplificateur différentiel 30 dont la sortie présente un signal [Bo*] qui ne correspond pas au bit de poids 0 de sortie du signal binaire, mais il peut en être déduit. Une porte OU Exclusif additionnelle 35 à l'entrée de laquelle sont appliqués les signaux [Bo*] et [B1] fournit en effet le signal [Bo] recherché.

Comme on le verra plus en détail par la suite, un tel encodeur permet de corriger automatiquement et rapidement des erreurs de décision en sortie du jeu de portes OU Exclusif 10.

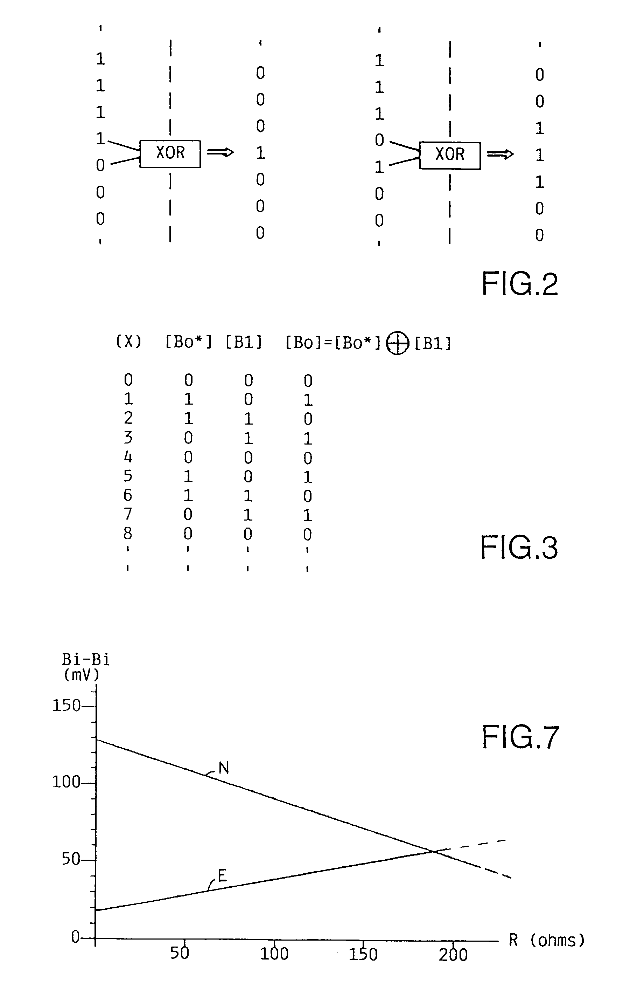

A l'aide de la figure 2 on va préciser maintenant ce qu'on entend par erreur de décision simple à la sortie du jeu de portes OU Exclusif 10. Conformément à la partie gauche de cette figure, les signaux d'entrée successifs sont combinées par des portes OU Exclusif (XOR) pour fournir en sortie un signal logique faisant apparaître normalement un seul état 1 qui correspond à la transition entre les entrées successives à l'état 1 et les entrées suivantes à l'état 0.

Dans la partie droite de la figure 2, est indiquée une série d'états à l'entrée du jeu de portes OU Exclusif 10 dont la transition entre l'état 1 et l'état 0 comporte trois changements successifs : de l'état 1 à l'état 0, puis de l'état 0 à l'état 1 et enfin de l'état 1 à l'état 0. Ces trois transitions en entrée fournissent, en sortie des portes OU Exclusif, trois états 1 successifs au lieu d'un seul. On admettra qu'en l'absence d'erreur, la seule ligne de sortie à l'état 1 aurait dû être celle qui est au centre des trois lignes de sortie à l'état 1. Ce type d'erreur est appelé "erreur simple de décision" parcequ'elle ne porte que sur trois lignes de rangs successifs alors que d'autres erreurs plus importantes feraient intervenir plus de trois lignes successives. Toutefois, les erreurs de décision dites simples sont également les plus fréquentes notamment lorsque la fréquence du signal à mesurer est augmentée.

La table de la figure 3 montre comment l'encodeur selon l'invention permet d'obtenir le bit de poids [Bo] de la sortie binaire à partir de la valeur [Bo*] en sortie de la paire de pseudo-colonnes de poids 0 et du bit [B1] de la sortie binaire de poids 1. Dans la colonne notée par (X) sont reportées les valeurs décimales successives représentées par les lignes successives lorsqu'elles sont à l'état haut. Ces valeurs décimales sont également indiquées à la figure 1, entre parenthèses. La colonne [Bo*] représente les états correspondants du signal différentiel en sortie de la paire de pseudo-colonnes de poids 0, la colonne notée [B1] indique les états successifs de la sortie binaire de poids 1 et la colonne [Bo] indique l'état obtenu par la relation[Bo] = [Bo*] $\oplus$ [B1].

On constate dans cette table que par le passage dans la porte OU Exclusif additionnelle 35 une sortie convenable du bit [Bo] de la sortie binaire est bien obtenue.

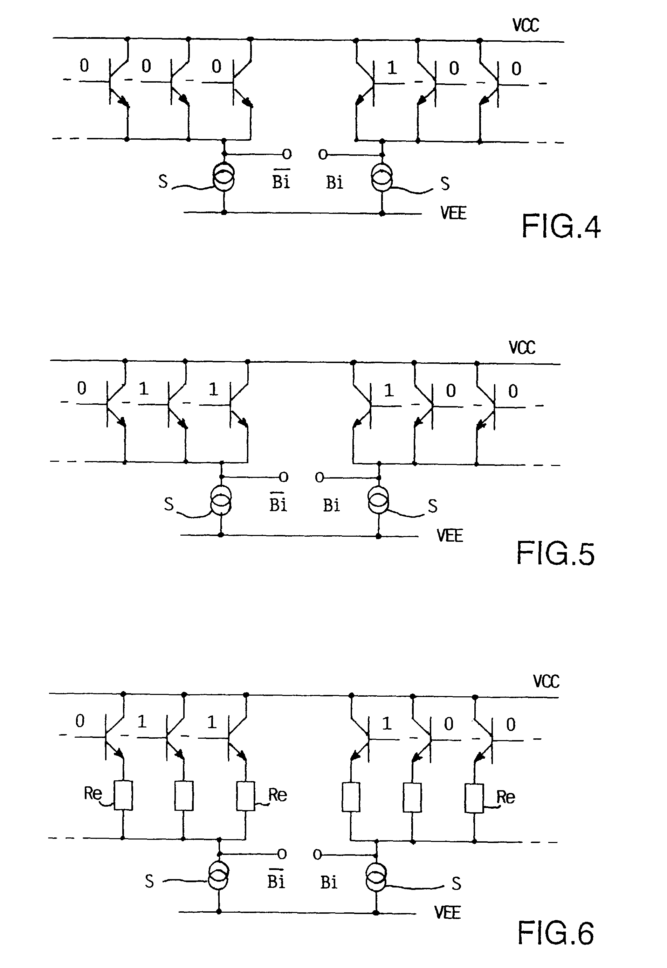

Les figures 4 et 5 vont permettre d'évaluer l'écart différentiel de tension produit sur les colonnes, d'une part lors d'une mesure normale, et d'autre part en présence d'une erreur de décision simple. Ces figures présentent de manière schématique les sorties Bi et $\bar{B}i$ d'une paire de colonnes Bi. Une paire de colonnes de poids i comporte n transistors de couplage répartis par moitié pour la colonne de poids i et pour moitié pour la colonne complémentaire de poids i.

En l'absence d'erreur (comme l'indique la figure 4) un seul des transistors de couplage a sa base portée à l'état haut et tous les autres transistors de couplage ont leur base portée à l'état bas. Les états sont représentés par les chiffres 1 et 0 sur les figures. Le signal différentiel Bi-$\bar{B}i$ peut donc être évalué de la manière suivante :

$$Bi - \bar{B}i = V_1 - V_{BE(lo)} - Vo + V_{BE(2lo/n)}$$

où lo est le courant débité par chacune des sources de courant S, $V_1$ et Vo sont les niveaux des tensions respectivement pour l'état logique haut et l'état logique bas des n lignes.

Notons $V_1 - Vo = V_{sw}$ ; il vient :

$$Bi - \bar{B}i = V_{sw} - V_T Ln(n/2) \tag{1}$$

relation dans laquelle $V_T = \frac{kT}{q} \approx 26mV$ à 300°K

k = constante de Boltzman
T = température absolue
q = charge de l'électron.

En établissant la relation (1), la contribution de courant apportée par les transistors dont la base est à l'état bas, en concurrence avec le transistor unique dont la base est à l'état haut, à été négligée.

En cas d'erreur de décision simple, trois transistors ont leur base à l'état haut. Lorsqu'il s'agit d'une paire de colonnes de poids i plus grand que 1, il peut se faire que les trois transistors dont la base est à l'état haut, soient du même côté, soit du côté Bi, soit du côté $\overline{B}i$. Ce cas n'induit aucune sorte de difficulté pour la sortie du signal Bi-$\overline{B}i$ du fait que ce signal est à un niveau peu différent (un peu plus élevé) de celui indiqué par la relation (1).

La figure 5 est au contraire relative au cas où, à la suite d'une erreur de décision simple, deux transistors sont actifs sur la colonne $\overline{B}i$ et un seulement sur la colonne Bi. Il est aisé de voir à l'aide des figures 1 et 2 que le transistor, qui aurait été actif en l'absence d'erreur de décision, doit se trouver du côté où deux transistors sont actifs simultanément. L'écart de tension Bi - $\overline{B}i$ devrait donc être négatif dans l'exemple. Les calculs qui suivent vont montrer que c'est effectivement le cas, mais le signal obtenu est de très faible amplitude. Avec les mêmes notations que précédemment, on peut écrire :

$$Bi - \overline{B}i = V_1 - V_{BE(Io)} - V_1 + V_{EE(Io/2)}$$

ce qui donne :

$$Bi - \overline{B}i = V_T Ln(1/2) = -V_T Ln(2) \tag{2}$$

soit environ -18mV.

Un tel signal est donc correct en ce qui concerne le signe, et une fois amplifié par un amplificateur tel que 30 ou 31... visible à la figure 1, ce signal peut être converti en un signal d'un niveau logique standard. En se référant à nouveau à la figure 1, on peut constater que le couplage entre ligne et colonne pour la paire de pseudo-colonnes de poids 0 est effectué de manière analogue à la paire de colonnes de poids 1, c'est-à-dire avec un couplage de deux lignes consécutives puis deux lignes non couplées, pour chaque colonne. Les pseudo-colonnes de poids 0 ont un comportement conforme à l'exemple de la figure 5.

On a déjà vu à l'aide de la figure 3 qu'en l'absence d'erreur de décision, les pseudo-colonnes de poids 0 permettent d'obtenir une sortie du bit convenable de poids 0 de la sortie binaire. En définitive en présence d'une erreur de décision simple, l'encodeur selon l'invention fournit également en sortie un bit de poids 0 correct.

La figure 6 représente un mode de réalisation de l'invention dans lequel une résistance Re est insérée entre les émetteurs des transistors et les colonnes. Par cette disposition il est possible d'augmenter le niveau différentiel de tension produit sur les colonnes lorsqu'une erreur de décision est présente. Toutefois, dans ce mode de mise en oeuvre, le niveau différentiel de tension produit sur les colonnes, en l'absence d'erreur, est réduit de manière corrélative.

En l'absence d'erreur de décision, on peut écrire :

$$Bi - \overline{B}i = V_1 - V_{BE(Io)} - R.Io - [VO - V_{BE(2Io/n)} - R.2Io/n]$$

avec R = valeur de la résistance Re ; soit encore :

$$Bi - \overline{B}i = V_{sw} - V_T Ln(n/2) - R.Io(1-\frac{2}{n}) \tag{3}$$

L'écart de tension Bi-$\overline{B}i$ se trouve réduit de la valeur :

$$R.Io \left(1 - \frac{2}{n}\right)$$

par rapport au cas où la résistance d'émetteur est omise.

Dans le cas d'une erreur de décision, on peut écrire :

$$Bi - \overline{B}i = V_1 - V_{BE(Io/2)} - R.Io/2 - [V_1 - V_{BE(Io)} - R.Io]$$

soit encore :

$$Bi - \bar{B}i = - (V_T \, Ln(2) + Rlo/2) \tag{4}$$

En valeur absolue, l'écart de tension est augmenté de Rlo/2 par comparaison avec la relation (2).

La figure 7 montre la courbe d'écart de tension Bi-$\bar{B}i$, en valeur absolue, d'une part dans le cas normal -courbe N-, et d'autre part en présence d'une erreur de décision simple -courbe E-, lorsque l'on fait varier la résistance d'émetteur Re. Les valeurs suivantes ont été utilisée, à titre d'exemple :

Io = 400 μA, courant débité par les sources de courant S

$V_{sw}$ = 200mV, écart des niveaux logiques en sortie des portes OU Exclusif

n=32

Il est clair qu'en augmentant la valeur des résistances d'émetteur Re, on peut augmenter considérablement le niveau différentiel de tension dans le cas d'une erreur de décision simple, et rendre ce niveau de tension comparable à celui qui est produit en l'absence d'erreur.

L'égalité de ces niveaux de tensions est obtenue pour une valeur de résistance R = voisine de 190Ω. Un écart de tension de l'ordre de 56mV est alors obtenu dans tous les cas, écart qui est confortable et permet d'utiliser des amplificateurs différentiels tels que montrés à la figure 1, aux repères 30, 31... d'une construction très simplifiée.

## Revendications

1. Encodeur pour la conversion d'un signal numérique d'entrée défini selon un code de type thermométrique ou circulaire dont chaque bit est appliqué à une entrée de l'encodeur, pour obtenir un signal de sortie codé en binaire, encodeur comportant un jeu (10) de n portes OU Exclusif successives (X1...Xi...Xn), à deux entrées et une sortie, chaque porte OU Exclusif (Xi) ayant une entrée reliée à une entrée de la porte (Xi-1), (Xi+1) de rang voisin ainsi qu'à une entrée (Ji) de l'encodeur, et comportant une matrice d'encodage (12) à n lignes en entrée et une pluralité de paires de colonnes (13-14), (15-16)... en sortie, chacune des n lignes successives étant reliée à une sortie d'une des portes OU Exclusif (Xi) successives, chacune des colonnes étant connectée à une borne de tension de référence (VEE) via une source de courant (S) et les colonnes d'une paire fournissant une sortie différentielle (23-24), (25-26) pour un bit [Bi] du signal binaire de sortie, matrice d'encodage dans laquelle un couplage actif entre une ligne déterminée et une colonne déterminée est constitué, lorsqu'il est requis, par un transistor (T) dont la base est reliée à ladite ligne déterminée, dont l'émetteur est relié à ladite colonne déterminée et dont le collecteur est relié à une borne de tension d'alimentation (Vcc),

   caractérisé en ce que la matrice d'encodage (12) comporte une paire de colonnes appelées respectivement pseudo-colonne de poids zéro (14) et pseudo-colonne complémentaire de poids zéro (13), dont le couplage lignes/colonnes est respectivement déduit par décalage circulaire à partir du couplage lignes/colonnes de la paire de colonnes (15-16) de poids un, à savoir : pour une ligne de rang i de la pseudo-colonne de poids zéro, est appliqué un couplage identique à celui de la ligne de rang (i modulo n) + 1 de la colonne de poids un, de même pour la ligne de rang i de la pseudo-colonne complémentaire de poids zéro, est appliqué un couplage identique à celui de la ligne de rang (i modulo n) + 1 de la colonne complémentaire de poids un,

   et en ce que l'encodeur comporte une porte OU Exclusif additionnelle (35) à deux entrées dont l'une reçoit un signal logique ([Bo*]) correspondant à la sortie de la paire de pseudo-colonnes de poids zéro (13-14) et l'autre reçoit un signal logique ([B1]) correspondant à la sortie de la paire de colonnes (15-16) de poids un, cette porte OU Exclusif additionnelle fournissant en sortie le bit de poids zéro ([Bo]) du signal binaire de sortie.

2. Encodeur selon la revendication 1, caractérisé en ce que chacune des paires de colonnes de la matrice d'encodage est suivie d'un amplificateur différentiel (30, 31...) de gain suffisant pour forcer le niveau de signal à sa sortie à prendre l'un parmi deux niveaux logiques prédéterminés, en présence d'une erreur de décision simple à la sortie du jeu (10) de portes OU Exclusif.

3. Encodeur selon l'une des revendications 1 ou 2, caractérisé en ce que dans la matrice d'encodage, chaque transistor (T) réalisant un couplage actif ligne/colonne est muni d'une résistance d'émetteur (Re) dont la valeur est choisie de manière à ce que le niveau différentiel de tension de la sortie d'une paire de colonnes en présence d'une erreur de décision simple à la sortie des portes OU Exclusif, soit rendu comparable au niveau différentiel de tension qui est produit en l'absence d'une telle erreur.

4. Convertisseur analogique/numérique caractérisé en ce qu'il comporte un encodeur selon l'une des revendications 1 à 3.

**Patentansprüche**

1. Coder zum Umsetzen eines Eingang-Binärsignals entsprechend einem thermometrischen oder ringförmigen Code, von dem jedes Bit an einen Eingang des Coders gelegt wird, um ein binärcodiertes Ausgangssignal zu erhalten, wobei der Coder eine Gruppe (10) von n zusätzlicher Exklusiv-ODER-Gattern (X1...Xi...Xn) mit zwei Eingängen und einem Ausgang enthält, jedes Exklusiv-ODER-Gatter (Xi) mit einem Eingang in Verbindung mit einem Eingang des Nachbargatters (Xi-1), (Xi+1) sowie in Verbindung mit einem Eingang (Ji) des Coders, und mit einer Codermatrix (12) aus n Zeilen am Eingang und einer Vielzahl von Spaltenpaaren (13-14), (15-16) ... am Ausgang versehen ist, wobei jede der n aufeinanderfolgenden Zeilen mit einem Ausgang eines der aufeinanderfolgenden Exklusiv-ODER-Gatter (Xi) verbunden ist, jede der Spalten mit einer Bezugsspannungsquelle (VEE) über eine Stromquelle (S) verbunden ist, und die Spalten eines Paares ein differenzielles Ausgangssignal (23-24), (25-26) für ein Bit [Bi] des Ausgang-Binärsignals liefern, in der Codermatrix eine aktive Kopplung zwischen einer vorgegebenen Zeile und einer vorgegebenen Spalte hergestellt wird, wenn es erforderlich ist für einen Transistor (T), dessen Basis mit der vorgegebenen Zeile verbunden, dessen Emitter mit der vorgegebenen Spalte verbunden, und dessen Kollektor an eine Speisespannungsquelle (Vcc) angeschlossen ist,
dadurch gekennzeichnet, daß die Codermatrix (12) ein Paar von Spalten mit der Bezeichnung Pseudospalte vom Wert Null (14) bzw. von komplementärer Pseudospalte vom Wert Null (13) enthält, dessen Zeilen/Spalten-Kopplung aus der ringförmigen Verschiebung ausgehend von der Zeilen/Spalten-Kopplung des Spaltenpaares (15-16) mit dem Wert Eins abgeleitet wird, d.h.: für eine Zeile vom Rang i der Pseudospalten vom Wert Null wird eine Kopplung gleich der der Zeile vom Rang (i Modulo n) + 1 der Spalte mit dem Wert Eins sowie für die Zeile vom Rang i der komplementären Pseudospalte vom Wert Null durchgeführt, wird eine Kopplung gleich der der Zeile vom Rang (i Modulo n) + 1 der komplementären Spalte mit dem Wert Eins durchgeführt, und daß der Coder ein zusätzliches Exklusiv-ODER-Gatter (35) mit zwei Eingängen enthält, von denen der eine ein logisches Signal ([Bo*]) entsprechend dem Ausgangssignal des Paares der Pseudospalten mit dem Wert Null (13-14) und der andere ein logisches Signal ([B1]) entsprechend dem Ausgangssignal des Paares der Spalten (15-16) mit dem Wert Eins empfangen, und dieser zusätzliche Exklusiv-ODER-Gatter am Ausgang das Bit mit dem Wert Null ([Bo]) des Ausgang-Binärsignals liefert.

2. Coder nach Anspruch 1, dadurch gekennzeichnet, daß jedem der Spaltenpaare der Codermatrix ein Differenzverstärker (30, 31 ...) mit ausreichender Verstärkung folgt, um dafür zu sorgen, daß für den Signalpegel an seinem Ausgang beim Auftreten eines einfachen Entscheidungsfehlers am Ausgang der Gruppe (10) der Exklusiv-ODER-Gatter ein aus zwei vorgegebenen logischen Pegeln genommen wird.

3. Coder nach einem der Ansprüche 1 oder 2, dadurch gekennzeichnet, daß in der Codermatrix jeder Transistor (T) der eine aktive Zeilen/Spalten-Kopplung verwirklicht, mit einem Emitterwiderstand (Re) versehen ist, dessen Wert derart gewählt wird, daß der differenzielle Spannungspegel des Ausgangs eines Spaltenpaares beim Auftreten eines einfachen Entscheidungsfehlers am Ausgang der Exklusiv-ODER-Gatter an den differenziellen Spannungspegel angeglichen wird, der bei Abwesenheit eines derartigen Fehlers erzeugt wird.

4. Analog/Digital-Wandler, dadurch gekennzeichnet, daß er einen Coder nach einem oder mehreren der Ansprüche 1 bis 3 enthält.

**Claims**

1. An encoder for the conversion of a digital input signal defined as a code of thermometric or cyclic type, each bit of which is applied to an input of the encoder, so as to obtain a binary-encoded output signal, which encoder includes a set (10) of n successive Exclusive OR gates (X1...Xi...Xn), with two inputs and one output, each Exclusive OR gate (Xi) having an input connected to an input of the gate (Xi-1), (Xi+1) of neighbouring rank as well as to an input (Ji) of the encoder, and includes an encoding matrix (12) with n rows at input and a plurality of pairs of columns (13-14), (15-16)... at output, each of the n successive rows being connected to an output of one of the successive Exclusive OR gates (Xi), each of the columns being linked to a reference voltage terminal (VEE) via a current source (S) and the columns of one pair delivering a differential output (23-24),(25-26) for one bit [Bi] of the binary output signal, in which encoding matrix active coupling between a specified row and a specified column is effected, when required, by a transistor (T), the base of which is connected to said specified row, the emitter of which is connected to said specified column and the collector of which is connected to a supply voltage terminal (Vcc), characterized in that the encoding matrix (12) includes a pair of columns respectively called pseudo-column (14) of order zero and complementary pseudo-column (13) of order zero, the row/column coupling of which is derived respectively through cyclic shifting from the row/column coupling of the pair of columns (15-16) of order one, namely : for a row of rank i of the pseudo-column of order zero, there is applied a coupling identical to that of the row of rank (i modulo n) + 1 of the column of order one, similarly for the row of rank i of the complementary pseudo-column of order zero, there is applied a coupling identical to that of the row of rank (i modulo n) + 1 of the complementary column of order one,

and in that the encoder includes an additional Exclusive OR gate (35) with two inputs, one of which receives a logic signal ([B0*])corresponding to the output from the pair of pseudo-columns (13-14) of order zero and the other of which receives a logic signal ([B1]) corresponding to the output of the pair of columns (15-16) of order one, this additional Exclusive OR gate delivering at output the bit ([B0]) of order zero of the binary output signal.

2. An encoder as claimed in claim 1, characterized in that each of the pairs of columns of the encoding matrix is followed by a differential amplifier (30,31...) of sufficient gain to force the signal level at its output to take one of two predetermined logic levels, in the presence of a simple decision error at the output of the set (10) of Exclusive OR gates.

3. An encoder as claimed in claim 1 or 2, characterized in that in the encoding matrix, each transistor (T) producing a row/column active coupling is furnished with an emitter resistor (Re), the value of which is chosen in such a way that the differential voltage level of the output from one pair of columns, in the presence of a simple decision error at the output of the Exclusive OR gates, is rendered comparable with the differential voltage level produced in the absence of such an error.

4. An analogue/digital converter, characterized in that it includes an encoder as claimed in any one of claims 1 to 3.

FIG.1

FIG.2

(X)    [Bo*]  [B1]   [Bo]=[Bo*] ⊕ [B1]

| (X) | [Bo*] | [B1] | [Bo]=[Bo*]⊕[B1] |
|---|---|---|---|
| 0 | 0 | 0 | 0 |
| 1 | 1 | 0 | 1 |
| 2 | 1 | 1 | 0 |
| 3 | 0 | 1 | 1 |
| 4 | 0 | 0 | 0 |
| 5 | 1 | 0 | 1 |
| 6 | 1 | 1 | 0 |
| 7 | 0 | 1 | 1 |
| 8 | 0 | 0 | 0 |

FIG.3

FIG.7

FIG.4

FIG.5

FIG.6